**Europäisches Patentamt**

**European Patent Office**

**Office européen des brevets**

(11) Veröffentlichungsnummer: **0 310 816 B1**

# EUROPÄISCHE PATENTSCHRIFT

(45) Veröffentlichungstag der Patentschrift: **06.11.91**

(51) Int. Cl.⁵: **H01J 37/256**

(21) Anmeldenummer: **88114378.8**

(22) Anmeldetag: **02.09.88**

(54) **Automatische Frequenznachführung bei Korpuskularstrahlmessverfahren unter Anwendung eines modulierten Primärstrahls.**

(30) Priorität: **30.09.87 DE 3733112**

(43) Veröffentlichungstag der Anmeldung:
**12.04.89 Patentblatt 89/15**

(45) Bekanntmachung des Hinweises auf die
Patenterteilung:
**06.11.91 Patentblatt 91/45**

(84) Benannte Vertragsstaaten:
**DE FR GB IT NL**

(56) Entgegenhaltungen:

**Dr.R.BEST "Theorie und Anwendungen des Phase-locked Loops", 2. ergänzte Auflage 1981 AT-VERLAG AARAU (CH)**

(73) Patentinhaber: **SIEMENS AKTIENGESELL-SCHAFT**
**Wittelsbacherplatz 2**
**W-8000 München 2(DE)**

(72) Erfinder: **Brust, Hans-Detlef**
**Martin-Luther-Strasse 2**
**W-6602 Dudweiler(DE)**

Rank Xerox (UK) Business Services

**Beschreibung**

Die Erfindung betrifft ein Verfahren und eine Vorrichtung zur Detektion und/oder Abbildung eines Punktes einer Probe, der ein Signal wenigstens einer bestimmten Frequenz führt, nach dem Oberbegriff des Anspruchs 1 und nach dem Oberbegriff des Anspruchs 10.

Es sind bisher eine Vielzahl von Methoden bekannt, die Signalverläufe hochfrequenter, periodischer Meßsignale mit dem Korpuskular- bzw. mit dem Elektronenstrahl zu erfassen. Eine Zusammenfassung der zur Zeit gängigen Testverfahren ist in der Veröffentlichung "Microelectronic Engineering" 4 (1986), Seiten 77 bis 106 "Electron Beam Testing" von E. Wolfgang, insbesondere auf Seite 83, wiedergegeben. Man unterscheidet Messungen, die im Zeitbereich und solche, die im Frequenzbereich erfolgen. Zum ersten gehört beispielsweise das "voltage coding" (siehe auch "Scanning Electron Microscopy" 1975 (Part I) Proc. of the Eigth Annual Scanning Electron Microscope Symposium, Chicago, IIT Research Institute, Seiten 465 bis 471) oder das "Logic State Mapping" (siehe auch US-Patentschrift US-A-4 223 220), während zu letzterem das sogenannte "Frequency-Mapping-Verfahren" oder "Frequency-Tracing"-Verfahren gehört. Bei beiden zuletzt genannten Meßverfahren richtet man den Elektronenstrahl auf den Meßpunkt und mißt das Frequenzspektrum bzw. eine einzelne Frequenzkomponente des dort anliegenden Signals.

Die DE-A-35 19 392 gibt ein Verfahren an, bei der mit Hilfe eines unmodulierten Primärelektronenstrahls eine Signalkomponente im Frequenzbereich gewonnen wird. Durch Variation der Mittenfrequenz eines durchstimmbaren Filters kann man das in Frage kommende Frequenzspektrum durchfahren und so bei unbekannter Frequenz die auf einem Meßpunkt, beispielsweise einer Leiterbahn in einem integrierten Schaltkreis, auftretenden Frequenzen feststellen.

Die Grundlagen des "Frequency-Mapping"-Verfahrens sind in der Veröffentlichung "Micro Electronic Engineering", Vol. 2, Nr. 4, 1985, "Frequency Tracing and Mapping in Theory and Practice" von H. D. Brust und F. Fox, Seiten 304 bis 311 und in der DE-OS 35 19 401 wiedergegeben. Beim "Frequency-Mapping" oder beim "Frequency-Tracing"-Verfahren muß das Strahlaustastsystem nicht mit kurzen elektrischen Pulsen angesteuert werden, wie beispielsweise beim "Logic State Mapping"-Verfahren, sondern es genügt eine Wechselspannung mit einer bestimmten Frequenz anzulegen, um den Primärstrahl zu modulieren. Im Prinzip ist auch die Ansteuerung mit einer rein sinusförmigen Spannung möglich. Durch geringen Frequenzversatz derjenigen Frequenz, mit der Primärstrahl moduliert wird, gegenüber der Frequenz des gesuchten Signals erreicht man, daß durch die Wechselwirkung des in der Probe ablaufenden periodischen Vorgangs mit dem Primärstrahl das gesuchte Signal stets auf eine feste Zwischenfrequenz gemischt wird. Diese feste Zwischenfrequenz kann sodann leicht ausgefiltert und danach demoduliert werden. Da die Signalkette eines Rasterelektronenmikroskops nur die relativ niedrige feste Zwischenfrequenz übertragen muß, können in einer Probe Signale sehr hoher Frequenz selektiert bzw. abgebildet werden. Durch Wobbeln derjenigen Frequenz, mit der der Primärstrahl moduliert wird, kann man das in Frage kommende Frequenzspektrum durchfahren und kann so bei unbekannter Frequenz eines gesuchten Signals die in einem Punkt der Probe auftretenden Frequenzen feststellen.

Im Gegensatz zu den meisten übrigen Verfahren der Elektronenstrahlmeßtechnik erfordert das "Frequency Mapping" oder das "Frequency Tracing"-Verfahren keine Synchronisation der Meßanordnung mit den Signalen in der zu untersuchenden Probe (beispielsweise in einer integrierten Schaltung). Beide eignen sich zur Untersuchung asynchroner Schaltungen. Es genügt bei diesen beiden Verfahren, daß die Frequenz der Probe sich um nicht mehr als die Bandbreite des Zwischenfrequenzfilters in der Elektronenstrahlmeßanordnung mit moduliertem Primärelektronenstrahl von der gesuchten Sollfrequenz unterscheidet.

Im Normalfall läßt sich die Bedingung relativ leicht erfüllen, jedoch kann es bei den zu untersuchenden Schaltungen - z.B. bei solchen mit eigenen Frequenzgeneratoren - zu Drifterscheinungen bezüglich der zu untersuchenden Frequenzen, beispielsweise aufgrund von Temperatureinwirkungen kommen. Entfernt sich die Frequenz auf der Probe jedoch um mehr als die Zwischenfrequenzbandbreite von der gesuchten Sollfrequenz, so erhält man beim "Frequency Tracing" und "Frequency Mapping"-Verfahren keine Meßergebnisse mehr.

Da derartige Drifterscheinungen im allgemeinen relativ langsam erfolgen, können sie durch manuelle Nachführung beispielsweise der Frequenz des Beam blanking-Generators in der Meßanordnung ausgeglichen werden. Dies ist bei der Untersuchung jedoch meist hinderlich und lenkt von dem eigentlichen Untersuchungsgegenstand ab.

Der Erfindung liegt die Aufgabe zugrunde, Drifterscheinungen in der zu untersuchenden Frequenz des Meßsignals auf der Probe zu kompensieren ohne manuelle Eingriffe von außen.

Diese Aufgabe wird erfindungsgemäß durch ein Verfahren nach dem kennzeichnenden Teil des ersten Anspruchs und durch eine Vorrichtung nach dem kennzeichnenden Teil des Anspruchs 10 gelöst.

Weitere Ausführungen sowie Realisierungen zum erfindungsgemäßen Verfahren sind Gegenstand der Unteransprüche und werden dort näher erläutert.

Die mit der Erfindung erzielten Vorteile liegen darin, daß das Verfahren universell sowohl für Elektronen, Ionen als auch auf Korpuskularstrahlung anwendbar ist und es ermöglicht solange die Frequenz der Probe nicht zu schnell wegdriftet die Abweichung von der gewünschten Sollfrequenz zu kompensieren und zu untersuchen.

Bei der untersuchten Probe kann es sich beispielsweise um eine integrierte Schaltung handeln. In der untersuchten integrierten Schaltung läuft jeweils ein periodischer Vorgang, zum Beispiel arbeitet ein Mikroprozessor wiederholt eine Programmschleife ab, so daß auf den Leiterbahnen der integrierten Schaltung periodisch elektrische Signale verschiedener Frequenz auftreten. Bestrahlt man eine solche Leiterbahn mit einem Primärelektronenstrahl, so lösen die Primärelektronen beim Auftreffen auf die Probenoberfläche niederenergetische Sekundärelektronen aus, die von einem Detektor abgesaugt und registriert werden können. Die Sekundärelektronen werden dabei von den durch die elektrischen Signale auf der Leiterbahn hervorgerufenen elektrischen Felder über der Probenoberfläche beeinflußt - eine Wechselwirkung, die man als Potentialkontrast bezeichnet.

Obwohl sich die folgenden Ausführungsbeispiele auf eine Elektronenmeßvorrichtung mit moduliertem Primärelektronenstrahl beziehen, ist die Erfindung so zu verstehen, daß anstelle von Elektronen auch Ionen oder andere Korpuskel verwendet werden können, und zwar sowohl als Primärkorpuskel als auch als Sekundärkorpuskel. Insbesondere kommen als Korpuskel auch Photonen in Betracht.

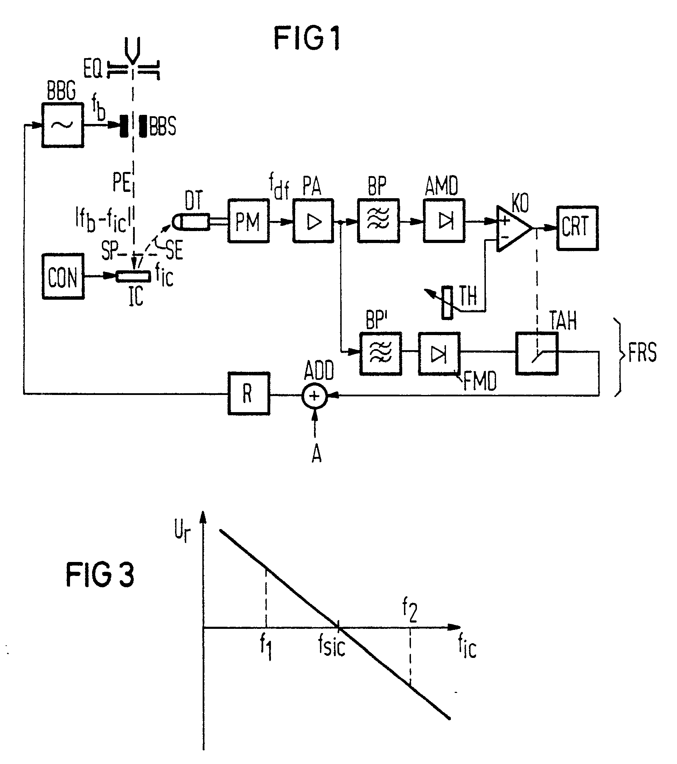

Ein Ausführungsbeispiel der Erfindung ist in der Figur 1 dargestellt und wird im folgenden näher beschrieben.

Es zeigen im einzelnen

Figur 1    eine erfindungsgemäße Anordnung nach dem Frequency Tracing-Verfahren, bei der Drifterscheinungen der Frequenz ($f_{ic}$) im Meßsignal der Probe durch Änderung der Frequenz am Beam blanking-Generator (BBG) kompensiert wird.

Figur 2, 4    Anordnung eines in der Figur 1 verwendeten FM-Demodulators.

Figur 3    Ausgangskennlinie eines FM-Demodulators nach Anordnung aus Figur 2.

Figur 5    Ausgangskennlinie eines FM-Demodulators nach Figur 4.

Figur 1 zeigt eine Vorrichtung nach der Erfindung zur Detektion und/oder Abbildung eines Meßpunktes, der ein Signal einer bestimmten Frequenz mit Hilfe eines modulierten Primärstrahls (PE) Führt und die mit einer erfindungsgemäßen Frequenzregelschaltung FRS ausgestattet ist. Als Grundgerät für eine solche Vorrichtung nach Figur 1 kann beispielsweise ein Rasterelektronenmikroskop verwendet werden, wie es aus den US-Patentschriften mit den Nummern US-A-4 220 853 bzw. US-A-4 220 854 bzw. US-A-277 679 für eine quantitative Potentialmessung und aus der US-Patentschrift US-A-4 223 220 für eine qualitative Potentialmessung bekannt ist. Auch bei der Vorrichtung nach der Figur 1 - ebenso wie bei einem Verfahren nach der Erfindung - kann selbstverständlich der integrierte Schaltkreis IC durch eine beliebige Probe ersetzt werden, die mindestens einen Meßpunkt aufweist, der ein Signal mit einer bestimmten Frequenz führt.

Bei einer Vorrichtung und einem Verfahren nach der Figur 1 wird der Primärelektronenstrahl mit Hilfe eines Strahlaustastsystems BBS mit einer bestimmten Frequenz $f_b$ moduliert. Ein geeignetes Strahlaustastsystem ist beispielsweise aus der US Patentschrift US-A-4 169 229 bekannt. Das Strahlaustastsystem BBS wird mit der Frequenz $f_b$ von einem Generator BBG angesteuert. Anstelle des Strahlaustastsystems BBS kann auch jedes andere System treten, das eine Intensitätsmodulation des Primärelektronenstrahls bewirkt. Hierfür kommt zum Beispiel auch der Wehneltzylinder der Elektronenquelle EQ in Betracht. Die Frequenz $f_b$ ist gegenüber der Frequenz $f_{ic}$, die ein gesuchtes Signal in einem Meßpunkt aufweisen soll, um die Frequenz $f_{df}$ versetzt. Die Zahl $f_{df}$ ist gleich dem Absolutbetrag der Differenz aus den Zahlen $f_b$ und $f_{ic}$. Wenn der Meßpunkt ein Signal mit der Frequenz $f_{ic}$ führt und wenn die Primärelektronen mit der Frequenz $f_b$ gepulst werden, enthält das Sekundärelektronensignal, wie es über den Detektor DT und über den Photomultiplier PM schließlich zum Ausgang des Vorverstärkers PA gelangt, ein Signal mit der Frequenz $f_{df}$. Ein auf den Vorverstärker PA folgendes Bandfilter BP weist als Mittenfrequenz die Frequenz $f_{df}$ auf. Daher filtert das Bandpaßfilter BP genau diese Frequenz $f_{df}$ aus dem Frequenzspektrum des Sekundärelektronensignals aus. Der durch das Bandpaßfilter BP hindurchgelassene Anteil des Sekundärelektronensignals wird in einem AM-Demodulator AMD demoduliert und anschließend an den Pluseingang eines Komparators KO angelegt. Der Minuseingang des Komparators KO ist mit einer variablen Ansprechschwelle TH verbunden. Der Ausgang des Komparators KO steuert die Intensität des Elektronenstrahls einer Bildröhre CRT, die Bestandteil des für eine Vorrichtung nach Figur 1 verwendeten Rasterelektronenmikroskops ist. Die x- und y-Eingänge der Bildröhreneinheit CRT können mit der Positionssteuerung des PE-Strahles verbunden werden. Dann erfolgt die Bewegung des Schreibstrahles der Bildröhre CRT synchron mit der Bewegung des PE-Strahles und es entsteht ein Bild der untersuchten integrierten Schaltung IC. Die integrierte Schaltung wird von einer Auswerteschaltung CON mit den erforderlichen Betriebsspannungen und gegebenenfalls Ansteuersignalen versorgt.

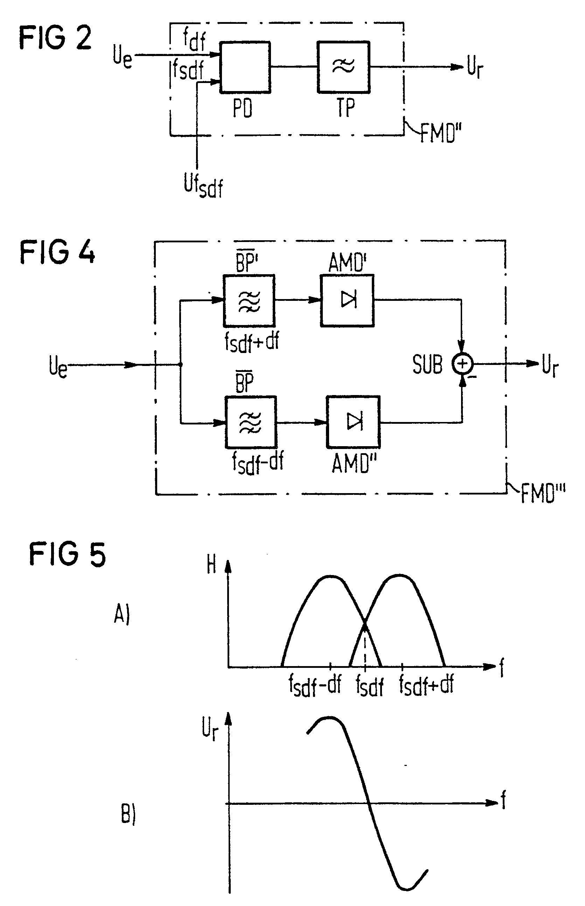

Die erfindungsgemäße Frequenzregelschaltung FRS besteht aus einem Bandpaß $BP'$, einem nachgeschalteten FM-Demodulator FMD, einem Addierer ADD, einem Regler R und falls notwendig aus einer Track- and Hold-Schaltung TAH, die durch das Ausgangssignal des Komparators KO gesteuert wird. Der Bandpaßfilter BP, der mit seinem Eingang mit dem Punkt in der Signalkette vor dem Bandpaßfilter BP und hinter dem Vorverstärker PA verbunden ist, dient zur Verbesserung des Signal-Rausch-Verhältnisses und ist nicht unbedingt erforderlich. Falls die Bandbreite des Filters BP groß genug ist, kann beispielsweise der Bandpaß BP selbst das Filter BP ersetzen. In diesem Fall wird das Ausgangssignal des Bandpasses BP dem FM-Demodulator FMD zugeführt. Der am Bandpaßfilter BP angeschlossene FM-Demodulator FMD, dessen mögliche Realisierung in der Figur 2 und Figur 4 angegeben ist, liefert ein Ausgangssignal, das die Abweichung der jeweils detektierten Frequenz von der Sollzwischenfrequenz $f_{sdf}$ angibt, sofern die detektierte Frequenz in einem Intervall ($f_{sdf}$ + df, $f_{sdf}$ - df) liegt. Dabei gibt 2df die minimale Bandbreite des Bandpaßfilters $BP'$ bzw. BP und des FM-Demodulators an. Ausgangskennlinien für solche FM-Demodulatoren zeigen die Figuren 3 und 5, für die besonders der zumindest stückweise streng monotone Verlauf der Ausgangskennlinie von Bedeutung ist. Das Ausgangssignal des FM Demodulators FMD wird über eine Track- and Hold-Schaltung TAH einem Addierer ADD zugeführt. Die Track-and Hold-Schaltung TAH, die in der in Fig. 1 dargestellten Realisierung durch das Ausgangssignal des Komparators KO gesteuert wird, schaltet die Frequenzregelschaltung FRS immer dann ein, wenn ein Signal der Frequenz $f_{ic}$ mit der Sollfrequenz $f_{sic}$ innerhalb eines fest vorgegebenen Abweichungsbereichs detektiert wird. Dieser Abweichungsbereich wird in dieser Realisierung maximal durch die Bandbreite des Bandpaßfilters BP und ansonsten durch eine entsprechende Dimensionierung der Track-and Hold-Schaltung TAH vorgegeben. Ist die Bandbreite des Filters BP relativ klein, so besteht die Gefahr, daß die Frequenz $f_{df}$ zu schnell aus dem Fangbereich der Regelung herausläuft. In einem solchen Fall ist es empfehlenswert, die Steuerung der Track- und Hold-Schaltung über ein zweites, breitbandigeres Filter - z,B. über den Bandpaß BP' -erfolgen zu lassen. Dazu wird dem zweiten Bandpaß ein zweiter AM-Demodulator nachgeschaltet, dessen Ausgangssignal dann nach Vergleich mit einem einstellbaren Schwellwert die Track- and Hold-Schaltung TAH steuert. In dem Addierer ADD wird das über die Track-and Hold-Schaltung TAH weitergeleitete Ausgangssignal des FM-Demodulators FMD mit einem die Sollzwischenfrequenz der integrierten Schaltung $f_{sdf}$ angebenden Spannungssignal zu Arbeitspunkteinstellung A verglichen. Der Vergleich erfolgt hier durch Addition des negierten Spannungssignals A zum Ausgangssignal des FM-Demodulators FMD mit Hilfe eines Addierers ADD. Die am Ausgang des Addierers anstehende Regeldifferenz wird sodann einem Regler R zugeführt. Auf den Addierer als eigenständiges Element kann verzichtet werden, z.B. wenn die Regeldifferenz im Regler R selbst bestimmt wird oder aber wenn der Arbeitspunkt gerade 0 V beträgt.

Bei dem Regler R kann es sich beispielsweise um einen Proportional-, einen Integral- oder einen Proportional-Integral-Regler handeln. Der Reglerausgang wird anschließend mit dem Beam-blanking Generator BBG verbunden, um einen Einfluß auf die Modulationsfrequenz $f_b$ ausüben zu können. Das Ausgangssignal des Reglers R steuert also die Ausgangsfrequenz $f_b$ des Beam-Blanking-Generators BBG. Entspricht die Frequenz $f_{ic}$ des detektierten Signals gerade der gewünschten Sollfrequenz $f_{sic}$ so wird die Modulationsfrequenz $f_b$ konstant gehalten, ist sie hingegen kleiner als die gewünschte Sollfrequenz $f_{sic}$ so wird mit Hilfe der Frequenzregelschaltung FRS und des Beam-blanking Generators BBG die Modulationsfrequenz $f_b$ erniedrigt. Im umgekehrten Fall, falls die detektierte Frequenz $f_{ic}$ größer als die Sollfrequenz $f_{sic}$ ist, wird die Modulationsfrequenz erhöht. Analog wie die Zwischenfrequenz $f_{df}$ = $|f_b - f_{ic}|$ ergibt sich die Sollzwischenfrequenz aus $f_{sdf}$ = $|f_b - f_{sic}|$ mit $f_{sic}$ als Sollfrequenz. Nun ist nicht überall in der integrierten Schaltung IC die gesuchte Frequenz $f_{ic}$ die der gewünschten Sollfrequenz $f_{sic}$ entsprechen soll, vorhanden. Meist beschränkt sich ihr Vorkommen auf einige Leiterbahnen. Daher werden mit Hilfe der Track-and Hold-Schaltung TAH lediglich Signale der integrierten Schaltung IC untersucht, deren Frequenz $f_{ic}$ der Sollfrequenz $f_{sic}$ entsprechen oder die sich um maximal einer zweiten fest vorgegebenen Differenzfrequenz unterscheiden. Gegebenenfalls kann man zur besseren Nachregelung auch den Elektronenstrahl, nach dem er eine gewisse Anzahl von Punkten abgetastet hat (zum Beispiel eine Zeile oder ein ganzes Bild) jeweils auf einen bestimmten Punkt, wo die Frequenz $f_{ic}$ und die Sollfrequenz $f_{sic}$ übereinstimmen, springen und ihn dort zur Nachregelung kurz verweilen lassen. In diesem Fall sollte die Steuerung der Track- and Hold-Schaltung TAH mit der Positionssteuerung des PE-Strahles gekoppelt werden. Immer wenn der PE-Strahl auf dem Vergleichspunkt verweilt, muß eine Nachregelung der Mittenfrequenz erfolgen, d.h. die Track-and Hold-Schaltung muß in den Tracking-Betrieb geschaltet werden. Ansonsten kann sie sich im Hold-Modus befinden.

Wird bei der Detektion der Sekundärelektronen SE in der Anordnung nach Figur 1 ein Spektrometer SP verwendet, wie es beispielsweise aus der US-Patentschrift 4 292 519 bekannt ist, so lassen sich quantitative Messungen durchführen. Bei Verwendung eines solchen Spektrometers SP können zusätzlich in absoluten Zahlenamplituden bestimmter Frequenzen in Frequenzspektrum, die an verschiedenen Meßpunkten ermittelt werden, verglichen werden.

Figur 2 zeigt einen ersten Aufbau eines FM-Demodulators $FMD''$ zur Verwendung in der Anordnung nach Figur 1. Figur 2 zeigt einen Teil einer PLL-Schaltung, mit einem Phasendetektor PD und einem nachgeschalteten Tiefpaß TP. Als Phasendetektor PD kann dabei insbesondere ein Mischer eingesetzt werden. Das detektierte Eingangssignal $U_e$ mit der Zwischenfrequenz $f_{df}$ wird in dem Phasendetektor PD mit einem Referenzsignal $Uf_{sdf}$ der Sollzwischenfrequenz $f_{sdf}$ verglichen. Das Ausgangssignal des Phasendetektors PD wird einem Tiefpaß TP zugeführt, und das tiefpaßgefilterte Signal dient dann als Regelsignal $U_r$. Ist die Bandbreite des Filters BP bzw. des "Lock-in"-Verstärkers LI relativ klein, so besteht die Gefahr, daß die Frequenz $f_{ic}$ zu schnell aus dem Fangbereich der Regelung herausläuft. In diesen Fällen ist es empfehlenswert, parallel zum Bandpaß BP einen zweiten, breitbandigeren Bandpaß anzubringen und von dessen Ausgang das Eingangssignal des FM-Demodulators $FMD''$ abzuleiten. Die Struktur der Schaltung entspricht dann der in Figur 1 dargestellten Realisierung. Gekoppelt damit oder unabhängig davon kann auch die Steuerung der Track- und Hold-Schaltung TAH verändert werden. Dazu wird hinter dem zweiten Bandpaß ein AM-Demodulator angebracht, dessen Ausgangssignal dann nach Vergleich mit einem einstellbaren Schwellwert die Track- und Hold-Schaltung steuert und damit bestimmt, wann nachgeregelt wird und wann nicht.

Figur 4 zeigt eine Ausgangskennlinie des Regelsignals $U_r$ in Abhängigkeit der Eingangszwischenfrequenz $f_{df}$ des Eingangssignals $U_e$. Dabei kommt es weniger auf die Linearität dieser Kennlinie an, als darauf, daß sie zumindest stückweise streng monoton, in diesem Fall streng monoton fallend, verläuft.

Besitzt das Eingangssignal $U_e$ die Frequenz $f_{sdf}$ gleich $f_{df}$ also die Sollzwischenfrequenz, so ist das Regelsignal $U_r$ gleich Null und es erfolgt keine Nachregelung der Frequenz $f_b$ des Beam-blanking-Generators BBG aus Figur 1. Die Frequenzen $f_1$ und $f_2$ markieren in der Ausgangskennlinie die Eckfrequenzen des Bandpaßfilters $BP'$ aus der Anordnung nach Figur 1 und geben an, daß Driftschwankungen der Zwischenfrequenz $f_{df}$ innerhalb des Frequenzbereiches ($f_1$ - $f_2$) durch die Frequenzregelschaltung FRS ausgeglichen werden können. Eine erste vorgegebene Differenzfrequenz von $|f_{df} - f_{sdf}|$ muß also immer kleiner sein als die Differenz der Eckfrequenz $|f_1 - f_2|$.

Immer wenn sich das detektierte Eingangssignal $U_e$ und das Referenzsignal $Uf_{sdf}$ in ihrer Frequenz und damit in ihrer Phase unterscheiden, ist das Regelsignal von Null verschieden. Der Nachteil dieser recht einfachen Schaltung liegt darin, daß ihre Regelzeitkonstante relativ groß ist und die Nachregelung deshalb sehr langsam erfolgt.

Die zweite Demodulatorschaltung $FMD'''$ nach Figur 4 vermeidet diesen Nachteil, ist dafür allerdings auch etwas aufwendiger in ihrem Aufbau. Hierzu benutzt man zwei Bandpaßfilter $\overline{BP}$, $\overline{BP}'$, deren Mittenfrequenz sich etwas (nämlich um df ≪ $f_{sdf}$) von der Sollzwischenfrequenz $f_{sdf}$ unterscheiden. Auf die Eingänge der beiden Bandpaßfilter wird das Eingangssignal $U_e$ mit der Frequenz $f_{df}$ aufgeschaltet. Die Ausgangssignale der Bandpaßfilter werden in je einem Hüllkurvendemodulator $AMD'$, $AMD''$, AM-demoduliert und sodann in einem Substrahierer SUB voneinander subtrahiert. Das so gewonnene Signal dient als Regelsignal $U_r$.

Figur 5B zeigt die Ausgangskennlinien der Demodulatorschaltung nach Figur 4 und Figur 5A veranschaulicht, wie sie realisiert wird. Figur 5A zeigt die Übertragungsfunktion H(f) der beiden Bandpässe mit unterschiedlichen Mittenfrequenzen ($f_{sdf}$ + $d_f$, $f_{sdf}$ - $d_f$). Durch Subtraktion der beiden Übertragungsfunktionen ergibt sich eine Frequenzkennlinie $U_r$(f) nach Figur 5B. Innerhalb des Frequenzbereiches $f_{sdf}$ - $d_f$ bis $f_{sdf}$ + $d_f$ ist wieder die gleiche streng fallende Monotonie der Ausgangskennlinien analog zur Ausgangskennlinie nach Figur 3 zu erkennen. Auch hier kann auf den Addierer verzichtet werden, da der optimale Arbeitspunkt der Schaltung bei null liegt (steilster Bereich der Kennlinie. Die Sollfrequenz $f_{sic}$ wird durch die Mittenfrequenzen der Bandpässe $\overline{BP}$ und $\overline{BP}'$ bestimmt. Zeichnet man das Regelsignal $U_r$ bzw. das Steuersignal, das die Ausgangsfrequenz $f_b$ des Beam-blanking-Generators steuert, über der Zeit t oder einem anderen Parameter, der für die Frequenzdrift von Bedeutung ist, wie etwa der Temperatur, auf, so kann man auf diese Weise eine automatische Messung des Frequenzdrifts einer integrierten Schaltung IC durchführen.

Die Verwendung eines Spektrometers SP in der Elektronenstrahlmeßanordnung nach Figur 1 ist nicht nur zur Spannungsmessung nützlich. Legt man an das Gegenfeldnetz eines Gegenfeldspektrometers eine konstante Spannung, so entsteht das Detektorsignal nicht mehr durch Potentialkontrast an der Probenoberfläche, sondern durch die Verschiebung der Sekundärelektronenenergieverteilung. Hierdurch werden Störeinflüsse lokaler Felder unterdrückt.

Weiterhin können anstelle des Potentialkontrasts auch andere Wechselwirkungen ausgenutzt werden. Dazu zählt beispielsweise die Beeinflußung der von einem Primärelektronen bzw. Laserstrahl erzeugten Sekundär- bzw. Photoelektronen durch ein magnetisches Feld. Durch Ausnutzung dieses sogenannten "magnetischen Kontrastes" ließe sich etwa die Bewegung magnetischer Domänen im Magnetblasenspeicher untersuchen.

Der Primärstrahl muß keineswegs ein Partikelstrahl sein, sondern kann auch aus einer beliebigen Strahlung bestehen. Benutzt man etwa einen Laserstrahl als Primärstrahl PE und wiederum eine integrierte Schaltung als Probe IC, so kann der Laserstrahl in den pn-Übergängen der Probe IC Elektronenlochpaare und damit freie Ladungsträger erzeugen. Dies macht sich dann in einer Änderung der Stromaufnahme der Probe IC bemerkbar. Wie groß diese Änderung ist, hängt auch vom Schaltzustand des jeweiligen pn-Überganges ab. Eine periodische Änderung des Schaltzustandes eines pn-Übergangs ließe sich daher leicht durch eine Messung des Versorgungsstromes der Probe IC feststellen. Der Versorgungsstrom der Schaltung bzw. seine Differenz zum Ruhestrom kann in diesem Falle unmittelbar als Meßsignal dienen, ein besonderer Detektor ist nicht erforderlich.

Die Mischung auf eine feste Zwischenfrequenz beruht auf einer nicht linearen Schaltkennlinie, hervorgerufen durch das Pulsen des Primärelektronenstrahls. Dies kann man aber ebenfalls erreichen, wenn man anstelle der Primärelektronen die Sekundärelektronen bzw. das Sekundärelektronensignal in ihrer Intensität moduliert. Dies ist beispielsweise möglich, indem man die Energieschwelle eines Gegenfeldspektrometers mit der Frequenz $f_b$ moduliert. Durch Berücksichtigung der Spektrometer-Kennlinie kann man sogar eine sinusförmige Modulation des Sekundärelektronensignals erreichen, und so eventuelle Schwierigkeiten mit Kreuzmodulationsprodukten, wie sie bei dem beschriebenen Verfahren unter Umständen auftreten, da die Primärelektronen beispielsweise auch mit Recktecksignalen gepulst werden können, vermeiden. Durch die höheren umzuladenden Kapazitäten und die Energiedisperiosn der Sekundärelektronen ist die Grenzfrequenz beim Pulsen einer Einrichtung in der Signalverarbeitung geringer. Außerdem wird durch das Spektrometer das Gesichtsfeld eingeschränkt. Analog kann man auch den Photomultiplier zusammen mit einer Gate-Schaltung betreiben oder im Video-Signalpfad modulieren. In diesem Fall wird die Bandbreite allerdings durch den Szintillator des Detektors stark eingeschränkt.

**Patentansprüche**

1. Verfahren zur Detektion und/oder qualitativen und/oder quantitativen Abbildung eines Punktes einer Probe, der ein Signal wenigstens einer bestimmten Frequenz ($f_{ic}$) führt, mit Hilfe eines Mikroskops, in dem der Punkt mit einem Primärstrahl (PE) beaufschlagt wird, wobei von dem Punkt ein sekundäres Signal, insbesondere über einen Detektor (DT) abgeleitet und gegebenenfalls zu einem Meßsignal weiterverarbeitet wird, daß der Primärstrahl (PE) oder eine Einrichtung zur Signalverarbeitung oder die Energieschwelle eines Spektrometers (SP) mit einer weiteren, insbesondere einstellbaren Frequenz ($f_b$) moduliert wird, wobei diese Frequenz ($f_b$) verschieden ist von der bestimmten Frequenz ($f_{ic}$), daß das sich ergebende Sekundärsignal oder Meßsignal auf eine bestimmte Zwischenfrequenz ($f_{df}$) gemischt wird und daß dieses sekundäre Signal oder Meßsignal demoduliert wird, **dadurch gekennzeichnet,** daß aus dem sekundären Signal oder Meßsignal ein Regelsignal ($U_r$) gewonnen wird, daß das Regelsignal ($U_r$) die einstellbare Frequenz ($f_b$) so regelt, daß die bestimmte Frequenz ($f_{ic}$) und eine vorgegebene Sollfrequenz ($f_{sic}$) maximal sich um eine erste vorgegebene Differenzfrequenz unterscheiden.

2. Verfahren nach Anspruch 1, **dadurch gekennzeichnet,** daß das sekundäre Signal und/oder das Meßsignal und/oder das Regelsignal aus einem elektrischen Signal besteht.

3. Verfahren nach Anspruch 1 oder 2, **dadurch gekennzeichnet,** daß das Regelsignal ($U_r$) aus dem sekundären Signal durch Ausfilterung und Demodulation gewonnen wird.

4. Verfahren nach Anspruch 3, **dadurch gekennzeichnet,** daß die Demodulation durch Phasenvergleich des ausgefilterten sekundären Signals mit einem Referenzsignal der Sollzwischenfrequenz ($Uf_{sdf}$) und einer nachfolgenden Tiefpaßfilterung erfolgt.

5. Verfahren nach Anspruch 3, **dadurch gekennzeichnet,** daß das sekundäre Signal durch zwei parallel geschaltete Bandpaßfilter ($\overline{BP}$, $\overline{BP'}$) mit unterschiedlicher Mittenfrequenz ($f_{sdf}$+df, $f_{sdf}$-df) in zwei Signalanteile unterschiedlich bewertet wird, daß jeder der Signalanteile hüllkurvendemoduliert wird, und anschließend die Signalanteile voneinander substrahiert werden.

6. Verfahren nach einem der Ansprüche 1 bis 5, **dadurch gekennzeichnet,** daß das Regelsignal ($U_r$) mit einem Signal der Sollzwischenfrequenz ($f_{sdf}$) zur Arbeitspunkteinstellung (A) verglichen wird, daß für den Fall, daß die einstellbare Frequenz ($f_b$) größer als die bestimmte Frequenz ($f_{ic}$) ist und sich die einstellbare Frequenz ($f_b$) als Summe der bestimmten Frequenz ($f_{ic}$) und der bestimmten Zwischenfrequenz ($f_{df}$) oder als Summe der Sollfrequenz ($f_{sic}$) und der Sollzwischenfrequenz ($f_{sdf}$) ergibt, die einstellbare Frequenz ($f_b$) erhöht wird, wenn die bestimmte Zwischenfrequenz ($f_{df}$) kleiner als die Sollzwischenfrequenz ($f_{sdf}$) ist, daß die einstellbare Frequenz ($f_b$) erniedrigt wird, wenn die bestimmte Zwischenfrequenz ($f_{df}$) größer als die Sollzwischenfrequenz ($f_{sdf}$) ist, daß die einstellbare Frequenz ($f_b$) nicht geändert wird, wenn die bestimmte Zwischenfrequenz ($f_{df}$) und die Sollzwischenfrequenz ($f_{sdf}$) übereinstimmen.

7. Verfahren nach einem der Ansprüche 1 bis 5, **dadurch gekennzeichnet,** daß das Regelsignal ($U_r$) mit einem Signal der Sollzwischenfrequenz ($f_{sdf}$) zur Arbeitspunkteinstellung (A) verglichen wird, daß für den Fall, daß die einstellbare Frequenz ($f_b$) kleiner als die bestimmte Frequenz ($f_{ic}$) ist und sich die einstellbare Frequenz ($f_b$) als Differenz aus der bestimmten Frequenz ($f_{ic}$) und der bestimmten Zwischenfrequenz ($f_{df}$) oder als Differenz der Sollfrequenz ($f_{sic}$) und der Sollzwischenfrequenz ($f_{sdf}$) ergibt, die einstellbare Frequenz ($f_b$) erniedrigt wird, wenn die bestimmte Zwischenfrequenz ($f_{df}$) kleiner als die Sollzwischenfrequenz ($f_{sdf}$) ist, daß die einstellbare Frequenz ($f_b$) erhöht wird, wenn die bestimmte Zwischenfrequenz ($f_{df}$) größer als die Sollzwischenfrequenz ($f_{sdf}$) ist, daß die einstellbare Frequenz ($f_b$) nicht geändert wird, wenn die bestimmte Zwischenfrequenz ($f_{df}$) und die Sollzwischenfrequenz ($f_{sdf}$) übereinstimmen.

8. Verfahren nach einem der Ansprüche 1 bis 7, **dadurch gekennzeichnet,** daß das Regelsignal die einstellbaren Frequenz ($f_b$) regelt, wenn ein Signal mit einer bestimmten Frequenz ($f_{ic}$) detektiert wird, und dabei eine Zwischenfrequenz ($f_{df}$) liefert, die sich von einer vorgegebenen Sollfrequenz ($f_{sdf}$) maximal um eine zweite vorgegebene Differenzfrequenz unterscheidet.

9. Verfahren nach einem der Ansprüche 1 bis 8, **dadurch gekennzeichnet,** daß der Primärstrahl auf einem Vergleichspunkt auf der Probe gerichtet wird und eine Nachregelung der einstellbaren Frequenz ($f_b$) vorgenommen wird.

10. Vorrichtung zur Detektion und/oder qualitativen und/oder quanitativen Abbildung eines Punktes einer Probe, der ein Signal wenigstens einer bestimmten Frequenz ($f_{ic}$) führt, mit Hilfe eines Mikroskops, mit einer Primärstrahlquelle (EQ) zur Emission eines Primärstrahls (PE), mit einer Signalkette zur Verarbeitung eines sekundären Signals, das von dem Punkt abgeleitet wird, insbesondere in ein elektrisches Meßsignal, wobei die Signalkette gegebenenfalls einen Detektor (DT) aufweist und mit einer Einrichtung (CRT) zum Aufzeichnen des von der Signalkette verarbeiteten sekundären Signals versehen ist, mit einem Generator (BBG) zur Ansteuerung eines Modulationssystems (BBS) zur Modulation des Primärstrahls (PE) oder zur Modulation einer Einrichtung zur Signalverarbeitung oder zur Modulation der Energieschwelle eines Spektrometers (SP) mit einer weiteren insbesondere einstellbaren Frequenz ($f_b$) die von der bestimmten Frequenz ($f_{ic}$) abweicht, **dadurch gekennzeichnet,** daß ein Eingang eines FM-Demodulators (FMD) mit der Signalkette an einer Stelle nach dem Detektor (DT) und vor einer Einheit zur Demodulation des Meßsignals AMD verbunden ist, daß ein Ausgang dem FM-Demodulators (FMD) mit einem Steuereingang des Generators (BBG) zur Ansteuerung des Modulationssystems (BBS) zur Modulation des Primärstrahls oder mit einer Einrichtung zur Signalverarbeitung oder mit einem Spektrometer verbunden ist.

11. Vorrichtung nach Anspruch 10, **dadurch gekennzeichnet,** daß zwischen FM-Demodulator (FMD) und dem Generator (BBG) zur Modulation des Primärstrahls ein Regler (R) angeordnet ist.

12. Vorrichtung nach Anspruch 11, **dadurch gekennzeichnet,** daß der Regler (R) ein Proportionalregler ist.

13. Vorrichtung nach Anspruch 8, **dadurch gekennzeichnet,** daß der Regler (R) ein Integralregler ist.

14. Vorrichtung nach einem der Ansprüche 11 bis 13, **dadurch gekennzeichnet,** daß ein Ausgang des FM-Demodulators (FMD) über einen Addierer (ADD) mit dem Regler (R) oder mit einer Einrichtung zur Signalverarbeitung oder mit einem Spektrometer verbunden ist, daß dem Addierer (ADD) über einen weiteren Eingang ein Signal zur Arbeitspunkteinstellung (A) zugeführt wird.

15. Vorrichtung nach einem der Ansprüche 11 bis 14, **dadurch gekennzeichnet,** daß hinter dem FM-Demodulator (FMD) und vor dem Regler (R) eine Track- and Hold-Schaltung (TAH) angeordnet ist.

16. Vorrichtung nach Anspruch 15, **dadurch gekennzeichnet,** daß das in der Signalkette aus dem sekundären Signal weiterverarbeitete Meßsignal als Steuerung für die Track- and Hold-Schaltung auf die Track- and Hold-Schaltung aufgeschaltet wird.

17. Vorrichtung nach einem der Ansprüche 10 bis 15, **dadurch gekennzeichnet,** daß vor dem FM-Demodulator (FMD) ein Bandpaßfilter (BP$'$) zur Verbesserung des Signalrauschverhältnisses angeordnet ist.

18. Vorrichtung nach einem der Ansprüche 10 bis 17, **dadurch gekennzeichnet,** daß der FM-Demodulator ein Phasendetektor (PD) mit nachgeschaltetem Tiefpaß (TP) enthält, daß der Phasendetektor (PD) mit einem ersten Eingang das sekundäre Signal mit einem zweiten Eingang ein Referenzsignal der Sollzwischenfrequenz ($f_{sdf}$) zugeführt wird.

19. Vorrichtung nach einem der Ansprüche 10 bis 17, **dadurch gekennzeichnet,** daß der FM-Demodulator zwei mit unterschiedlicher Mittenfrequenz ausgestatteter Bandpaßfilter ($\overline{BP}$, $\overline{BP'}$) zwei Hüllkurvendemodulatoren (AMD$'$, AMD$''$) und einen Substrahierer (SUB) enthält, daß Eingänge der Bandpaßfilter gemeinsam einen Eingang des FM-Demodulators (FMD$''$) bilden, daß je ein Bandpaßfilter über je ein Hüllkurvendemodulator mit dem Subtrahierer (SUB) verbunden ist, daß am Ausgang des Substrahierers ein Ausgang des FM-Demodulators (FMD$''$) bildet.

## Claims

1. Method for the detection and/or qualitative and/or quantitative imaging of a point of a specimen which carries a signal of at least one specific frequency ($f_{ic}$) with the aid of a microscope, in which the point is subjected to a primary beam (PE), a secondary signal being derived from the point, preferably via a detector (DT), and, if desired, being further processed to form a test signal, such that the primary beam (PE) or a signal processing device or the energy threshold of a spectrometer (SP) is modulated with a further, preferably adjustable, frequency ($f_b$), which differs from the specific frequency ($f_{ic}$) such that the resulting secondary signal or test signal is mixed onto a specific intermediate frequency ($f_{df}$) and that this secondary signal or test signal is demodulated, characterised in that a control signal ($U_r$) is extracted from the secondary signal or test signal, in that the control signal ($U_r$) controls the adjustable frequency ($f_b$) such that the specific frequency ($f_{ic}$) and a prescribed nominal frequency ($f_{sic}$) differ by, at most, a first prescribed difference frequency.

2. Method according to Claim 1, characterised in that the secondary signal and/or the test signal and/or the control signal consists of an electrical signal.

3. Method according to Claim 1 or 2, characterised in that the control signal ($U_r$) is extracted from the secondary signal by filtering and demodulation.

4. Method according to Claim 3, characterised in that the demodulation is carried out by phase comparison of the filtered secondary signal with a reference signal at the nominal intermediate frequency ($Uf_{sdf}$) and subsequent low-pass filtering.

5. Method according to Claim 3, characterised in that the secondary signal is differently evaluated by two parallel-connected bandpass filters ($\overline{BP}$, $\overline{BP}'$) having different centre frequencies ($f_{sdf} + df$, $f_{sdf}-df$) in two signal components, in that each of the signal components is envelope-curve demodulated, and the signal components are subsequently subtracted from each other.

6. Method according to one of Claims 1 to 5, characterised in that the control signal ($U_r$) is compared with a signal at the nominal intermediate frequency ($f_{sdf}$) for adjusting the operating point (A), in that in the case where the adjustable frequency ($f_b$) is greater than the specific frequency ($f_{ic}$), and the adjustable frequency ($f_b$) is the result of the sum of the specific frequency ($f_{ic}$) and the specific intermediate frequency ($f_{df}$), or of the sum of the nominal frequency ($f_{sic}$) and the nominal intermediate frequency ($f_{sdf}$), the adjustable frequency ($f_b$) is increased when the specific intermediate frequency ($f_{df}$) is less than the nominal intermediate frequency ($f_{sdf}$), in that the adjustable frequency ($f_b$) is reduced when the specific intermediate frequency ($f_{df}$) is greater than the nominal intermediate frequency ($f_{sdf}$), in that the adjustable frequency ($f_b$) is not changed when the specific intermediate frequency ($f_{df}$) and the nominal intermediate frequency ($f_{sdf}$) coincide.

7. Method according to one of Claims 1 to 5, characterised in that the control signal ($U_r$) is compared with a signal at the nominal intermediate frequency ($f_{sdf}$) for adjusting the operating point (A), in that in the case where the adjustable frequency ($f_b$) is less than the specific frequency ($f_{ic}$), and the adjustable frequency ($f_b$) is the result of the difference between the specific frequency ($f_{ic}$) and the specific intermediate frequency ($f_{df}$) or the difference between the nominal frequency ($f_{sic}$) and the nominal intermediate frequency ($f_{sdf}$), the adjustable frequency ($f_b$) is reduced when the specific intermediate frequency ($f_{df}$) is less than the nominal intermediate frequency ($f_{sdf}$), in that the adjustable frequency ($f_b$) is increased when the specific intermediate frequency ($f_{df}$) is greater than the nominal intermediate frequency ($f_{sdf}$), in that the adjustable frequency ($f_b$) is not changed when the specific intermediate frequency ($f_{df}$) and the nominal intermediate frequency ($f_{sdf}$) coincide.

8. Method according to one of Claims 1 to 7, characterised in that the control signal controls the adjustable frequency ($f_b$) when a signal at a specific frequency ($f_{ic}$) is detected and in this case supplies an intermediate frequency ($f_{df}$) which differs from a prescribed nominal frequency ($f_{sdf}$) by, at most, a second prescribed difference frequency.

9. Method according to one of Claims 1 to 8, characterised in that the primary beam is directed onto a comparison point on the specimen, and a readjustment of the adjustable frequency ($f_b$) is carried out.

10. Apparatus for the detection and/or qualitative and/or quantitative imaging of a point of a specimen which carries a signal of at least one specific frequency ($f_{ic}$) with the aid of a microscope, having a primary beam source (EQ) for the emission of a primary beam (PE), having a signal chain for processing a secondary signal which is derived from the point, preferably to form an electrical test signal, the signal chain exhibiting, if desired, a detector (DT) and being provided with a device (CRT) for recording the secondary signal processed by the signal chain, having a generator (BBG) for driving a modulation system (BBS) for modulating the primary beam (PE) or for modulating a signal processing device or for modulating the energy threshold of a spectrometer with a further, preferably adjustable, frequency ($f_b$) which differs from the specific frequency ($f_{ic}$), characterised in that one input of an FM demodulator (FMD) is connected to the signal chain at a point downstream from the detector (DT) and upstream of a unit for demodulation of the test signal (AMD), in that one output of the FM demodulator (FMD) is connected to a control input of the generator (BBG) for driving the modulation system (BBS) for modulating the primary beam, or to a signal processing device or to a spectrometer.

11. Apparatus according to Claim 10, characterised in that a controller (R) is arranged between the FM demodulator (FMD) and the generator (BBG) for modulation of the primary beam.

12. Apparatus according to Claim 11, characterised in that the controller (R) is a proportional controller.

13. Apparatus according to Claim 8, characterised in that the controller (R) is an integral controller.

14. Apparatus according to one of Claims 11 to 13, characterised in that one output of the FM demodulator (FMD) is connected via an adder (ADD) to the controller (R) or to a signal processing device or to a spectrometer, in that a signal for adjusting the operating point (A) is supplied to the adder (ADD) via a further input.

15. Apparatus according to one of Claims 11 to 14, characterised in that a track-and-hold circuit (TAH) is arranged downstream from the FM demodulator (FMD) and upstream of the controller (R).

16. Apparatus according to Claim 15, characterised in that the test signal further processed in the signal chain from the secondary signal is connected to the track-and-hold circuit as control for the track-and-hold circuit.

17. Apparatus according to one of Claims 10 to 15, characterised in that a bandpass filter (BP') is arranged upstream of the FM demodulator (FMD) for improving the signal-to-noise ratio.

18. Apparatus according to one of Claims 10 to 17, characterised in that the FM demodulator contains a phase detector (PD) having a low-pass filter (TP) connected downstream, in that the phase detector (PD) is supplied with the secondary signal at a first input and a reference signal at the nominal intermediate frequency ($f_{sdf}$) at a second input.

19. Apparatus according to one of Claims 10 to 17, characterised in that the FM demodulator contains two bandpass filters ($\overline{BP}$, $\overline{BP}'$), provided with different centre frequencies, two envelope-curve demodulators (AMD', AMD'') and a subtractor (SUB), in that the inputs of the bandpass filter form a common input of the FM demodulator (FMD'''), in that in each case one bandpass filter is connected via in each case one envelope-curve demodulator to the subtractor (SUB), and in that an output of the FM demodulator (FMD''') is formed at the output of the subtractor.

**Revendications**

1. Procédé pour détecter et/ou pour former qualitativement et/ou quantitativement l'image d'un point d'un échantillon, qui posséde un signal possédant au moins une fréquence déterminée ($f_{ic}$), à l'aide d'un microscope, dans lequel un faisceau primaire (PE) est appliqué au point, et selon lequel un signal secondaire est tiré du point, notamment par l'intermédiaire d'un détecteur (DT), et subit éventuellement un post-traitement pour former un signal de mesure, que le faisceau primaire (PE) ou un dispositif pour traiter les signaux ou le seuil d'énergie d'un spectromètre (SP) était modulé par une autre fréquence notamment réglable ($f_b$), qui est différente de la fréquence déterminée ($f_{ic}$), alors que le signal secondaire ou le signal de mesure obtenu est mélangé à une fréquence intermédiaire déterminée ($f_{df}$) et que ce signal secondaire ou signal de mesure est démodulé, caractérisé par le fait qu'à partir du signal secondaire ou du signal de mesure, on obtient un signal de régulation ($U_r$), que ce signal de régulation ($U_r$) règle la fréquence réglable ($f_b$) de manière que la fréquence déterminée ($f_{ic}$) et une fréquence de consigne prédéterminée ($f_{sic}$) diffèrent d'une première fréquence différentielle prédéterminée.

2. Procédé suivant la revendication 1, caractérisé par le fait que le signal secondaire et/ou le signal de mesure et/ou le signal de régulation est formé par un signal électrique.

3. Procédé suivant la revendication 1 ou 2, caractérisé par le fait que le signal de régulation ($U_r$) est obtenu à partir du signal secondaire par séparation par filtrage et démodulation.

4. Procédé suivant la revendication 3, caractérisé par le fait que la démodulation est réalisée au moyen d'une comparaison de phase du signal secondaire extrait par filtrage à un signal de référence possédant la fréquence interémdiaire ($Uf_{sy}$) et au moyen d'un post-filtrage passe-bas.

5. Procédé suivant la revendication 3, caractérisé par le fait que le signal secondaire est évalué différemment, par deux filtres passe-bande ($\overline{BP}$, $\overline{BP}'$) branchés en parallèle et possédant des fréquences centrales différentes ($f_{sdf}$ + df, $f_{sdf}$-df), suivant deux composantes du signal, que la courbe enveloppe de chacune des composantes du signal est démodulée, et qu'ensuite, les composantes du signal sont soustraites l'une de l'autre.

6. Procédé selon l'une des revendications 1 à 5, caractérisé par le fait que le signal de modulation ($U_r$) est comparé à un signal possédant la fréquence intermédiaire de consigne ($f_{sdf}$) pour le réglage (A) du point de fonctionnement, que dans le cas où la fréquence réglable ($f_b$) est supérieure à la fréquence déterminée ($f_{ic}$) et que la fréquence réglable ($f_b$) est obtenue en tant que somme de la fréquence déterminée ($f_{ic}$) et de la fréquence intermédiaire déterminée ($f_{df}$) ou en tant que somme de la fréquence de consigne ($f_{sic}$) et de la fréquence intermédiaire de consigne ($f_{sdf}$), on augmente la fréquence réglable ($f_b$) lorsque la fréquence intermédiaire déterminée ($f_{sdf}$) est inférieure à la fréquence intermédiaire continue ($f_{sdf}$), qu'on réduit la fréquence réglable ($f_b$) lorsque la fréquence intermédiaire déterminée ($f_{df}$) est supérieure à la fréquence intermédiaire de consigne ($f_{sdf}$), et qu'on ne modifie pas la fréquence réglable ($f_b$) lorsque la fréquence intermédiaire déterminée ($f_{df}$) et la fréquence intermédiaire de consigne ($f_{sdf}$) sont égales.

7. Procédé selon l'une des revendications 1 à 5, caractérisé par le fait que le signal de régulation ($U_r$) est comparé à un signal de la fréquence intermédiaire de consigne ($f_{sdf}$) pour le réglage (A) du point de fonctionnement, que dans le cas où la fréquence réglable ($f_b$) est inférieure à la fréquence déterminée ($f_{ic}$) et où la fréquence réglable ($f_b$) est obtenue en tant que différence entre la fréquence déterminée ($f_{ic}$) et la fréquence intermédiaire déterminée ($f_{df}$) ou en tant que différence entre la fréquence de consigne ($f_{sic}$) et la fréquence intermédiaire de consigne ($f_{sdf}$), on réduit la fréquence réglable ($f_b$) lorsque la fréquence intermédiaire déterminée ($f_{df}$) est inférieure à la fréquence intermédiaire de consigne (f$_{sdf}$), qu'on accroît la fréquence réglable (f$_b$) lorsque la fréquence intermédiaire déterminée (f$_{df}$) est supérieure à la fréquence intermédiaire de consigne (f$_{sdf}$),et qu'on ne modifie pas la fréquence réglable (f$_b$) lorsque la fréquence intermédiaire déterminée (f$_{df}$) et la fréquence intermédiaire de consigne (f$_{sdf}$) sont égales.

8. Procédé suivant l'une des revendications 1 à 7, caractérisé par le fait que le signal de régulation règle la fréquence réglable (f$_b$) lorsqu'un signal possède la fréquence déterminée (f$_{ic}$) détectée, et fournit une fréquence intermédiaire (f$_{df}$), et diffère de la fréquence de consigne prédéterminée (f$_{sdf}$), au maximum d'une seconde fréquence différentielle déterminée.

9. Procédé suivant l'une des revendications 1 à 8, caractérisé par le fait qu'on dirige le faisceau primaire sur un point de comparaison de l'échantillon et qu'on exécute un post-réglage de la fréquence réglable (s$_b$).

10. Dispositif pour détecter et/ou pour former de façon qualitative et/ou quantitative l'image d'un point d'un échantillon, qui transmet un signal possédant au moins une fréquence déterminée (f$_{ic}$), à l'aide d'un microscope, et comportant une source de faisceau primaire (EQ) servant à émettre un faisceau primaire (PE), une chaîne de transmission de signaux servant à traiter un signal secondaire qui est obtenu à partir du point, notamment pour obtenir un signal de mesure électrique, la chaîne de transmission de signaux possédant éventuellement un détecteur (DT) et comportant un dispositif (CRT) servant à enregistrer le signal secondaire traité par la chaîne de transmission de signaux, et comportant un générateur (BBG) servant à commander un système de modulation (BBS) pour moduler le faisceau primaire (PE) ou moduler un dispositif de traitement des signaux ou de modulation du flux d'énergie d'un spectromètre (SP) avec une autre fréquence notamment réglable (f$_b$), qui diffère de la fréquence déterminée (f$_{ic}$), caractérisé par le fait qu'une entrée d'un démodulateur de fréquence (FMD) est raccordée à la chaîne de transmission de signaux en un emplacement situé en aval du détecteur (DT) et en amont de l'unité de démodulation du signal de mesure AMD, qu'une sortie du démodulateur de fréquence (FMD) est raccordée à une entrée de commande du générateur (BBG) pour la commande du système de modulation (BBS) servant à moduler le faisceau primaire ou un dispositif de traitement de signaux ou un spectromètre.

11. Dispositif suivant la revendication 10, caractérisé par le fait qu'un régulateur (R) est disposé entre le démodulateur de fréquence (SMD) et le générateur (BBG) pour la modulation du faisceau primaire.

12. Dispositif suivant la revendication 11, caractérisé par le fait que le régulateur (R) est un régulateur à action proportionnelle.

13. Dispositif suivant la revendication 8, caractérisé par le fait que le régulateur (R) est un régulateur à action intégrale.

14. Dispositif suivant l'une des revendications 11 à 13, caractérisé par le fait qu'une sortie du démodulateur de fréquence (FMD) est raccordée par l'intermédiaire d'un additionneur (ADD) au régulateur (R) ou à un dispositif de traitement de signaux ou un spectromètre, qu'un signal pour le réglage (A) du point de fonctionnement est envoyé à l'additionneur (ADD) par l'intermédiaire d'une autre entrée.

15. Dispositif suivant l'une des revendications 11 à 14, caractérisé par le fait qu'un circuit de poursuite et de blocage (TAH) est disposé en aval du démodulateur de fréquence (FMD) et en amont du régulateur (R).

16. Dispositif suivant la revendication 15, caractérisé par le fait que le signal de mesure, dont le traitement se poursuit dans la chaîne de transmission de signaux à partir du signal secondaire, est appliqué au circuit de poursuite et de blocage en tant que commande de ce circuit.

17. Dispositif suivant l'une des revendications 10 à 15, caractérisé par le fait qu'un filtre passebande (BP') servant à améliorer le rapport signal/bruit est disposé en amont du démodulateur de fréquence (FMD).

18. Dispositif suivant l'une des revendications 10 à 17, caractérisé par le fait que le démodulateur de fréquence comporte un détecteur de phase (PD) en aval duquel est branché un filtre passe-bas (TP), que le signal secondaire est envoyé à une première entrée du détecteur de phase (PD) et qu'un signal de référence possédant la fréquence intermédiaire de consigne (f$_{sdf}$) est envoyé à une seconde entrée du détecteur de phase.

19. Dispositif suivant l'une des revendications 10 à 17, caractérisé par le fait que le démodulateur de fréquence comporte deux filtres passe-bande ($\overline{BP}$, $\overline{BP'}$) possédant des fréquences centra-

les différentes, deux démodulateurs de courbes enveloppes (AMD', AMD") et un soustracteur (SUB), que des entrées des filtres passe-bande forment en commun une entrée du démodulateur de fréquence (FMD"'), que respectivement un filtre passe-bande est raccordé au soustracteur (SUB) par l'intermédiaire d'un démodulateur de courbe enveloppe et que la sortie du soustracteur forme une sortie du démodulateur de fréquence (FMD"').

# FIG 1

# FIG 3

FIG 2

FIG 4

FIG 5